# EUROPÄISCHE PATENTSCHRIFT

(11) **EP 0 920 706 B1**
(45) Veröffentlichungstag und Bekanntmachung des Hinweises auf die Patenterteilung: **22.03.2000**
(21) Anmeldenummer: 97938747.9
(22) Anmeldetag: 06.08.1997
(51) Int. Cl.: H01H 50/02, H05K 5/02

(54) **ELEKTRISCHES BAUELEMENT**
ELECTRICAL COMPONENT
COMPOSANT ELECTRIQUE

(30) Priorität: 21.08.1996 DE 19633727
(43) Veröffentlichungstag der Anmeldung: 09.06.1999
(73) Patentinhaber: SIEMENS AKTIENGESELLSCHAFT, 80333 München (DE)
(72) Erfinder: KERN, Josef, D-13629 Berlin (DE)
(86) Internationale Anmeldenummer: DE9701658
(87) Internationale Veröffentlichungsnummer: WO9808242

(56) Entgegenhaltungen:
- WO-A-95/14366
- DE-U- 9 111 106
- PATENT ABSTRACTS OF JAPAN vol. 007, no. 212 (P-224), 20.September 1983 & JP 58 106463 A (NITSUSHIN DENKI KK), 24.Juni 1983,

## Beschreibung

Die Erfindung betrifft ein elektrisches Bauelement mit einem blockförmigen Gehäuse und mit auf mindestens einer Gehäuseseite austretenden Anschlußstiften. Insbesondere betrifft die Erfindung dabei elektromechanische Bauelemente, wie Relais, Relaismodule und dergleichen.

Elektromagnetische Relais, elektromechanische Baugruppen und Geräte können durch Handhabungsfehler bei der Montage auf den Boden fallen und müssen deshalb fallresistent sein, d.h., sie müssen bei einer vorgegebenen Fallhöhe von beispielsweise 1 oder 2 m den auftretenden Stoß ohne innere Schäden oder Funktionseinschränkungen überstehen. Um zu vermeiden, daß ein äußerlich unbeschädigt aussehendes Bauelement aufgrund solcher Schädigungen sich nach dem Einbau als funktionsuntüchtig herausstellt, wird gefordert, daß das Gerät einen freien Fall aus einer bestimmten Höhe entweder ohne Vorschädigung übersteht oder daß die Schädigung auch äußerlich sichtbar wird.

Gehäuse von Relais, Baugruppen und Geräten sind meist zur Ausnutzung eines größtmöglichen Innenraumes außen großflächig eben gestaltet und haben im Innenraum Rippen und Vorsprünge, um das Bauteil gegen Stoß- und Schockbelastung zu fixieren. Da die Stoßabsorption von Kunststoffgehäusen, die auch einen mechanischen Schutz der Bauteile gewährleisten müssen und deshalb aus einem Kunststoff hoher Festigkeit gefertigt sind, sehr klein ist, muß ein relativ hoher Konstruktionsaufwand am Bauteil im Gehäuse getrieben werden, damit dieses einen Falltest ohne verdeckte Beschädigung übersteht. Dieser hohe Aufwand muß nur für den selten vorkommenden Fall getrieben werden, bei dem das Bauteil durch einen Handhabungsfehler vor dem eigentlichen Einsatz fallengelassen wird. Im normalen Einsatz des Bauelements treten derartige Stoßbelastungen während der gesamten Lebensdauer nicht mehr auf.

Aus WO-A-95/14366 ist ein Gehäuse für Fernbedienungen bekannt, das aus elastischem Material besteht und auf seinen Oberflächen allseitig mit elastischen Rippen versehen sein kann. Auf diese Weise sollen die Bauelemente im Inneren wie auch das Gehäuse selbst vor Schäden bei Stößen, wie sie etwa durch Hinunterfallen entstehen können, geschützt werden. Die Elastizität des Gehäuses und der Rippen läßt aber äußerlich auch dann nichts erkennen, wenn überstarke Stöße trotzdem zu Beschädigungen der Funktionselemente im Inneren geführt haben.

In der DE-U-9111106 ist weiterhin ein Sensor zum Einbau in Kraftfahrzeugen beschrieben, der zum Schutz vor Beschädigungen zusätzlich in eine Verpackung aus elastischem, Stöße kompensierendem Material eingesetzt ist. Diese Verpackung besteht aus geschäumtem Kunststoffmaterial und soll auch beim Einbau des Sensors mit ihm verbunden bleiben. Da diese Verpackung aber ein Mehrfaches des eigentlichen Sensorvolumens ausmacht, kann eine derartige Lösung für Bauelemente, die beispielsweise auf Leiterplatten eingesetzt werden sollen, nicht in Betracht kommen.

Aus JP-A-58106463 ist weiterhin ein elektrisches Gerät mit Metallgehäuse bekannt, bei dem zur Erkennung von schädlichen Stößen ein zusätzlicher Stoßdetektor außenseitig am Gehäuse angebracht ist. Auch diese Lösung ist wegen des zusätzlichen Volumens und des Kostenaufwandes bei kleinen Bauelementen nicht anwendbar.

Ziel der vorliegenden Erfindung ist es, ein Gehäuse für ein elektrisches Bauelement mit möglichst wenig Aufwand so zu gestalten, daß unzulässige Stoßbeanspruchungen zuverlässig von außen erkennbar sind, wobei diese Gestaltung durch entsprechende Dimensionierung an die zulässige Grenze angepaßt werden kann, bis zu der die Funktionselemente im Inneren des Bauelementes Stöße ohne Schädigung überstehen.

Erfindungsgemäß wird dieses Ziel dadurch erreicht, daß auf den Gehäuseaußenseiten jeweils deformierbare Vorsprüngen vorgesehen sind, welche die Außenkonturen des Gehäuses allseitig, - ausgenommen gegebenenfalls Gehäuseseiten mit vorstehenden Anschlußelementen - überragen, und daß diese Vorsprünge bis zu einer vorgegebenen Stoßbelastung elastisch und bei einer die vorgegebene Größe übersteigenden Stoßbelastung plastisch deformierbar sind.

Diese erfindungsgemäßen Vorsprünge in Form von Rippen oder Noppen können an den Außenflächen oder vorzugsweise an den Außenkanten des Gehäuses angeformt sein, wobei sie problemlos im Spritzgießverfahren zusammen mit dem eigentlichen Gehäuse aus Kunststoff geformt werden können, so daß kaum ein Mehraufwand entsteht. Diese Vorsprünge, die beliebige Gestalt haben können, sind durch ihre entsprechend dünnwandige Ausführung nicht so formstabil wie das übrige dickwandige Gehäuse, so daß sie sich beim Auftreten des Bauteiles auf einen harten Fußboden - bei entsprechender Fallhöhe - verformen. Bei geringer Fallhöhe wird die durch die Bauteilmasse im freien Fall gespeicherte Energie in den Vorsprüngen des Gehäuses absorbiert, so daß die negative Beschleunigung wesentlich herabgesetzt wird und das Bauteil im Inneren des Gehäuses vor einer verdeckten Beschädigung geschützt wird. Die Dimensionierung der Vorsprünge bezüglich ihrer Höhe, Querschnitte und Gestalt als Rippen oder Noppen kann dem Bauteil und seiner Anwendung angepaßt werden. So können durch die Art und Dimensionierung der Vorsprünge die Masse des Bauteiles, der verwendete Gehäusekunststoff und auch die vorgeschriebene Fallhöhe, die das Bauteil ohne Beschädigung überstehen muß, berücksichtigt werden.

Die Vorsprünge an den Außenkanten oder Gehäuseoberflächen können, wie erwähnt, aus demselben Material wie das Gehäuse selbst gefertigt werden. Sie können aber auch aus einem elastischen Kunststoff mit dem Gehäuse im Zwei-Komponenten-Spritzgießverfahren hergestellt werden; in diesem Fall wird zweckmäßigerweise das Bauteilgehäuse aus einem Kunststoff höherer Steifigkeit gefertigt, während die Vorsprünge eine entsprechend geringere Steifigkeit aufweisen.

Da durch die erfindungsgemäße Gestaltung die erwähnten Schädigungen bei der falschen Handhabung, die nur in sehr seltenen Fällen auftreten, zuverlässig erkannt werden, kann die Stoßbelastung des Bauelementes selbst, d.h. seiner Funktionselemente, relativ gering sein, so daß sie für die geringeren Stöße beim normalen Einsatz ausreicht. So können die im Bauteil verwendeten Werkstoffe unter Umständen durch ein kostengünstigeres Material geringerer Festigkeit ersetzt werden; in anderen Fällen kann auch eine Querschnittsverkleinerung einzelner Kunstruktionselemente erfolgen und eine Kosteneinsparung bringen. Somit kann also der für den Fall einer Stoßbeanspruchung bei einem selten vorkommenden Handhabungsfehler betriebene Aufwand kostensenkend verringert werden. Durch die Dimensionierung der Vorsprünge und durch die Materialauswahl werden Handhabungsfehler erkannt, wenn eine äußere Beschädigung der Vorsprünge, sei es durch Abplatzen oder durch eine Deformation, vorhanden ist. Das Bauteil kann aussortiert werden, so daß die Vorschädigung nicht zu einem Ausfall beim Betrieb des Gerätes führt.

Die Erfindung wird nachfolgend an Ausführungsbeispielen anhand der Zeichnung näher erläutert. Es zeigt
Figur 1 ein erfindungsgemäß gestaltetes Relais,
Figur 2 eine gegenüber Figur 1 leicht abgewandelte Ausführungsform eines Relais,
Figur 3 einen Längsschnitt durch ein Relaisgehäuse gemäß Figur 1,
Figur 4 einen Detailausschnitt IV aus Figur 3 und
Figur 5 eine Abwandlung des Detailausschnittes von Figur 4.

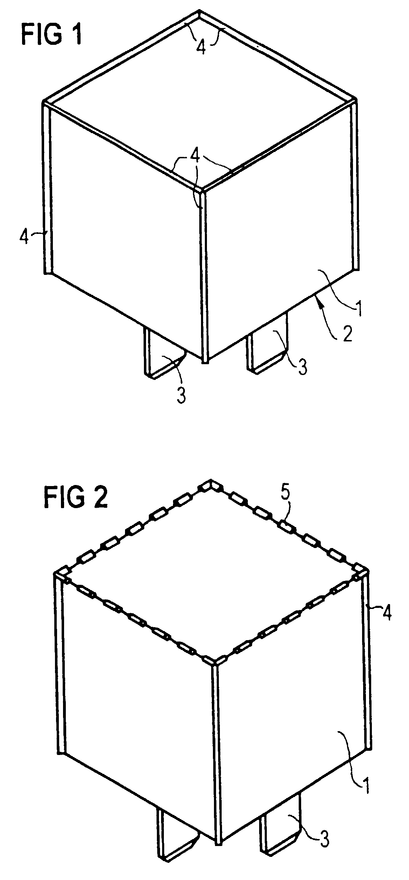

Figur 1 zeigt als Ausführungsform für ein erfindungsgemäßes Bauelement ein Relais mit einem quaderförmigen bzw. würfelförmigen Gehäuse 1, das durch eine Gehäusekappe und einen nicht sichtbaren Sockel gebildet wird. An der Unterseite 2 des Gehäuses treten im Sockel verankerte Flachstecker 3 aus. Auf allen Außenkanten zwischen den Wänden der Gehäusekappe sind durchgehende Rippen 4 angeformt, die sich mit relativ geringem Querschnitt in Richtung der Mittelsenkrechten zwischen je zwei Gehäuseseiten 11 nach außen erstrecken. Lediglich zur Unterseite 2 des Gehäuses hin sind derartige Vorsprünge oder Rippen nicht erforderlich, da auf dieser Seite ohnehin die Flachstecker oder sonstige Anschlußelemente nach außen vorstehen.

Die Rippen 4 an den Außenkanten der Kappe gewährleisten eine dämpfende Wirkung bei einem beliebigen Fall des Relais auf einen harten Untergrund, wenn dieses mit einer der fünf Seitenflächen bzw. mit einer der Kanten auftrifft. Übersteigt jedoch der Aufprallstoß eine vorgegebene Grenze, bei der eine Schädigung der Bauteilfunktion zu erwarten ist, so wird diese Schädigung durch eine bleibende Deformation einer der Rippen erkennbar. Beim Auftreffen mit der Unterseite 2 auf den Boden würden die Anschlußstifte bzw. Flachstecker 3 sichtbar verbogen, so daß auch in diesem Fall der Handhabungsfehler - wie bisher - erkennbar ist. Bei Gehäusen mit vertieft liegenden Anschlußsteckern oder -stiften können die Vorsprünge allseitig auf den Außenkonturen (d.h. auf 12 Außenkanten des quaderförmigen Gehäuses) angebracht werden.

Die Rippen 4 gemäß Figur 1 sind in besonders einfacher Weise spritzgießtechnisch mit der Kappe in einer schieberlosen Spritzgießform herstellbar. Sie können aus demselben Werkstoff wie das Gehäuse selbst oder auch aus einem beispielsweise elastischen, thermoplastischen Kunststoff im Zwei-Komponenten-Spritzgießverfahren hergestellt sein.

Anstelle der Rippen 4 können Vorsprünge in beliebigen anderen Formen gewählt werden. Beispielsweise ist in Figur 2 eine Ausführungsform gezeigt, bei der die Rippen an der Gehäuseoberseite unterbrochen sind, so daß einzelne Noppen 5 entstehen. Diese Noppen könnten natürlich auch andere Formen, beispielsweise die Form von Stiften oder Kegeln, erhalten. Sie könnten auch von den Gehäusekanten abgesetzt auf den Seitenflächen vorgesehen werden. Es muß lediglich sichergestellt werden, daß bei einem beliebigen Auftreffen des Gehäuses auf einen Untergrund mit einer der fünf Seitenflächen der Aufprall zuerst mit mindestens einem Vorsprung erfolgt.

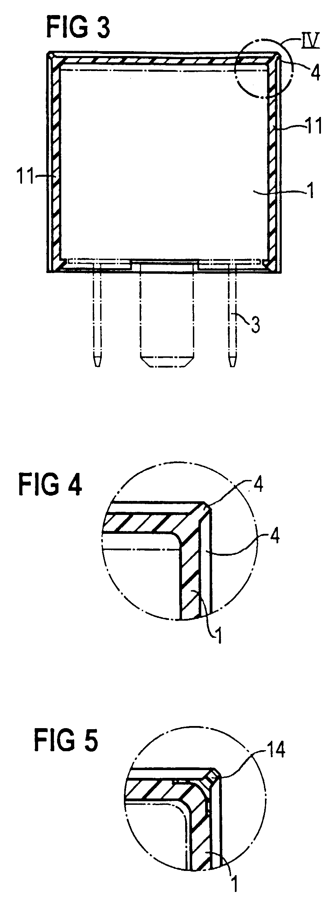

Figur 3 zeigt einen Schnitt durch die Gehäusekappe eines Relais nach Figur 1 (ohne Innenkonstruktion). Dabei ist zu sehen, daß sich die Rippen 4 in Richtung der Winkelsenkrechten zwischen zwei Gehäuseseiten 11 nach außen erstrecken. Auf diese Weise wirkt eine Rippe als Stoßdämpfung bzw. als Stoßanzeige für jeweils zwei angrenzende Gehäuseseiten.

Figur 4 zeigt den Querschnitt durch eine Rippe in einer Detailvergrößerung.

Figur 5 zeigt den gleichen Detailausschnitt wie Figur 4, jedoch mit der Modifizierung, daß eine Rippe 14 aus einem anderen Material als das Gehäuse 1 gefertigt ist.

## Patentansprüche

1. Elektrisches Bauelement mit einem blockförmigen Gehäuse (1) und mit auf mindestens einer Gehäuseseite (2) austretenden Anschlußstiften (3),
**dadurch gekennzeichnet**, daß auf den Gehäuseaußenseiten jeweils deformierbare Vorsprünge (4,5;14) vorgesehen sind, welche die Außenkonturen des Gehäuses allseitig, - ausgenommen gegebenenfalls Gehäuseseiten mit vorstehenden Anschlußelementen - überragen, und daß diese Vorsprünge (4,5;14) bis zu einer vorgegebenen Stoßbelastung elastisch und bei einer die vorgegebene Größe übersteigenden Stoßbelastung plastisch deformierbar sind.

2. Bauelement nach Anspruch 1,
**dadurch gekennzeichnet**, daß das Gehäuse aus Kunststoff besteht und daß die Vorsprünge (4,5) aus demselben Material einstückig angeformt sind.

3. Bauelement nach Anspruch 1,
**dadurch gekennnzeichnet**, daß das Gehäuse mit den Vorsprüngen (14) im Zwei-Komponenten-Spritzgießverfahren aus zwei elastischen Kunststoffen unterschiedlicher Steifigkeit hergestellt ist, wobei das Gehäuse selbst eine höhere Steifigkeit besitzt als die Vorsprünge (14).

4. Bauelement nach einem der Ansprüche 1 bis 3,
**dadurch gekennzeichnet**, daß die Vorsprünge (4,5;14) jeweils auf den Kanten entlang der Winkelhalbierenden zwischen zwei Gehäuseseiten nach außen gerichtet sind.

5. Bauelement nach einem der Ansprüche 1 bis 4,
**dadurch gekennzeichnet**, daß die Vorsprünge (4;14) die Form von Rippen besitzen.

6. Bauelement nach einem der Ansprüche 1 bis 4,
**dadurch gekennzeichnet**, daß die Vorsprünge die Form von Noppen (5) bzw. unterbrochenen Rippen besitzen.

## Claims

1. Electrical component having a housing (1) in the form of a block and having connection pins (3) emerging on at least one housing side (2), characterized in that the outer sides of the housing are respectively provided with deformable projections (4,5;14) which protrude beyond the outer contours of the housing on all sides - with the possible exception of housing sides having protruding connection elements -, and in that these projections (4,5;14) are elastically deformable up to a specified impact stress and are plastically deformable with an impact stress exceeding the specified magnitude.

2. Component according to Claim 1, characterized in that the housing is made of plastic, and in that the projections (4,5) are integrally formed on it and made of the same material.

3. Component according to Claim 1, characterized in that the housing with the projections (14) is produced from two elastic plastics of differing stiffness using the two-component injection-moulding process, the housing itself having a greater stiffness than the projections (14).

4. Component according to one of Claims 1 to 3, characterized in that the projections (4,5;14) are respectively directed outwards on the edges along the bisector between two housing sides.

5. Component according to one of Claims 1 to 4, characterized in that the projections (4;14) are shaped as ribs.

6. Component according to one of Claims 1 to 4, characterized in that the projections are shaped as nubs (5) or interrupted ribs.

## Revendications

1. Composant électrique comprenant un boîtier (1) ayant la forme d'un bloc et des broches de connexion (3) sortant sur au moins un côté (2) du boîtier,
caractérisé en ce que l'on prévoit à chaque fois, sur les côtés extérieurs du boîtier, des saillies déformables (4, 5 ; 14) qui dépassent sur tous les côtés les contours extérieurs du boîtier - à l'exception, le cas échéant, des côtés du boîtier pourvus d'éléments de connexion saillants -, et en ce que ces saillies (4, 5; 14) peuvent subir une déformation élastique jusqu'à une charge par à-coups prédéfinie et une déformation plastique en présence d'une charge par à-coups dépassant la grandeur prédéfinie.

2. Composant selon la revendication 1, caractérisé en ce que le boîtier se compose de matière plastique et en ce que les saillies (4, 5) sont formées de manière solidaire dans le même matériau.

3. Composant selon la revendication 1, caractérisé en ce que le boîtier est fabriqué avec les saillies (14) dans deux matières plastiques élastiques ayant des rigidités différentes au cours d'un procédé de moulage par injection à deux composants, le boîtier lui-même ayant une plus grande rigidité que les saillies (14).

4. Composant selon l'une des revendications 1 à 3, caractérisé en ce que les saillies (4, 5 ; 14) sont à chaque fois dirigées vers l'extérieur sur les arêtes, le long des bissectrices entre deux côtés du boîtier.

5. Composant selon l'une des revendications 1 à 4, caractérisé en ce que les saillies (4 ; 14) ont la forme de nervures.

6. Composant selon l'une des revendications 1 à 4, caractérisé en ce que les saillies ont la forme de nopes (5) resp. de nervures interrompues.
